# EUROPEAN PATENT APPLICATION

(11) **EP 4 435 865 A1**
(43) Date of publication of application: **25.09.2024**
(21) Application number: 23192310.3
(22) Date of filing: 21.08.2023
(51) Int. Cl.: H01L 29/06, H01L 29/08, H01L 29/78

(54) **SEMICONDUCTOR DEVICE**

(30) Priority: 22.03.2023 JP 2023046007
(71) Applicant: KABUSHIKI KAISHA TOSHIBA, Minato-ku Tokyo 105-0023 (JP); Toshiba Electronic Devices & Storage Corporation, Tokyo 105-0023 (JP)
(72) Inventor: TANAKA, Katsuhisa, Tokyo, 105-0023 (JP); KONO, Hiroshi, Tokyo, 105-0023 (JP)
(74) Representative: Kramer Barske Schmidtchen Patentanwälte PartG mbB

(57) **Abstract**

A semiconductor device according to an embodiment includes a gate electrode extending in a first direction, a gate insulation film that covers the gate electrode, a first semiconductor region of a first conductivity type extending in a second direction orthogonal to the first direction below the gate insulation film, and a second semiconductor region of the first conductivity type that faces the gate insulation film across the first semiconductor region. An impurity concentration of the first conductivity type of the second semiconductor region is lower than that of the first semiconductor region.

## Description

### FIELD

An embodiment of the present invention relates to a semiconductor device.

### BACKGROUND

Some power semiconductor devices, such as a MOSFET (Metal Oxide Semiconductor Field Effect Transistor), have a structure in which a p⁺-type semiconductor region is partially provided on a lower side of a trench-gate electrode extending in one direction. Such a structure can mitigate the electric field of a gate insulation film covering the gate electrode.

In such semiconductor devices, when the p⁺-type semiconductor region is thick, the on resistance could increase. On the other hand, when the p⁺-type semiconductor region is thin, dimensions significantly vary, which could degrade the reliability of the gate insulation film.

### BRIEF DESCRIPTION OF THE DRAWINGS

FIG. 1 is a cross sectional view of a semiconductor device according to a first embodiment that is cut in a perpendicular direction;
FIG. 2 is a cross sectional view of the semiconductor device according to the first embodiment that is cut in the perpendicular direction at a portion different from that of FIG. 1;
FIG. 3 is a cross sectional view taken along a cutting line A-A shown in FIG. 1 and a cutting line C-C shown in FIG. 2;
FIG. 4 is a cross sectional view taken along a cutting line B-B shown in FIG. 1 and a cutting line D-D shown in FIG. 2;
FIG. 5 is a cross sectional view for explaining a step of forming a p-type semiconductor region;
FIG. 6 is a cross sectional view for explaining a step of forming first to third current spreading regions;
FIG. 7 is a cross sectional view for explaining a step of forming a p⁺-type semiconductor region;
FIG. 8 is a cross sectional view for explaining a step of forming an n⁻-type semiconductor region;
FIG. 9 is a cross sectional view for explaining a step of forming a fourth current spreading region;
FIG. 10 is a cross sectional view for explaining a step of forming the fourth current spreading region that is cut at a portion different from that of FIG. 9;
FIG. 11 is a cross sectional view for explaining a step of forming a p-base region, an n⁺ source region, a p⁺ contact region, and a trench;
FIG. 12 is a cross sectional view for explaining the step of forming the p-base region, the n⁺ source region, the p⁺ contact region, and the trench that are cut at a portion different from that of FIG. 11;
FIG. 13 is a cross sectional view for explaining a step of forming the p⁺-type semiconductor region in a side wall portion of the trench;
FIG. 14 is a cross sectional view for explaining a step of forming a gate insulation film, a gate electrode, and an interlayer dielectric;
FIG. 15 is a cross sectional view for explaining the step of forming the gate insulation film, the gate electrode, and the interlayer dielectric that are cut at a portion different from that of FIG. 14;
FIG. 16 is a cross sectional view of a semiconductor device according to a first modification that is cut in a perpendicular direction;
FIG. 17 is a cross sectional view of the semiconductor device according to the first modification that is cut in the perpendicular direction at a portion different from that of FIG. 16;
FIG. 18 is a cross sectional view of a semiconductor device according to a second embodiment that is cut in a perpendicular direction;
FIG. 19 is a cross sectional view of the semiconductor device according to the second embodiment that is cut in the perpendicular direction at a portion different from that of FIG. 18;
FIG. 20 is a cross sectional view of a semiconductor device according to a second modification that is cut in a perpendicular direction; and
FIG. 21 is a cross sectional view of the semiconductor device according to the second modification that is cut in the perpendicular direction at a portion different from that of FIG. 20.

### DETAILED DESCRIPTION

Embodiments will now be explained with reference to the accompanying drawings. The present invention is not limited to the embodiments.

A semiconductor device according to an embodiment includes a gate electrode extending in a first direction, a gate insulation film that covers the gate electrode, a first semiconductor region of a first conductivity type extending in a second direction orthogonal to the first direction below the gate insulation film, and a second semiconductor region of the first conductivity type that faces the gate insulation film across the first semiconductor region. An impurity concentration of the first conductivity type of the second semiconductor region is lower than an impurity concentration of the first conductivity type of the first semiconductor region.

### (First embodiment)

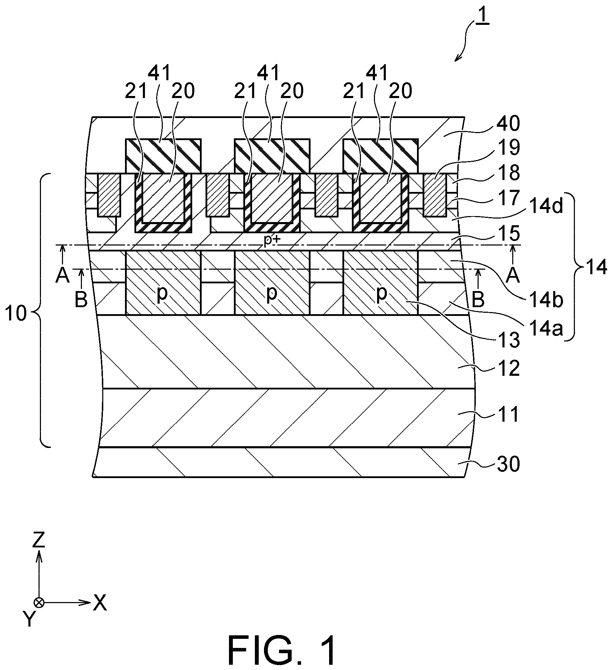

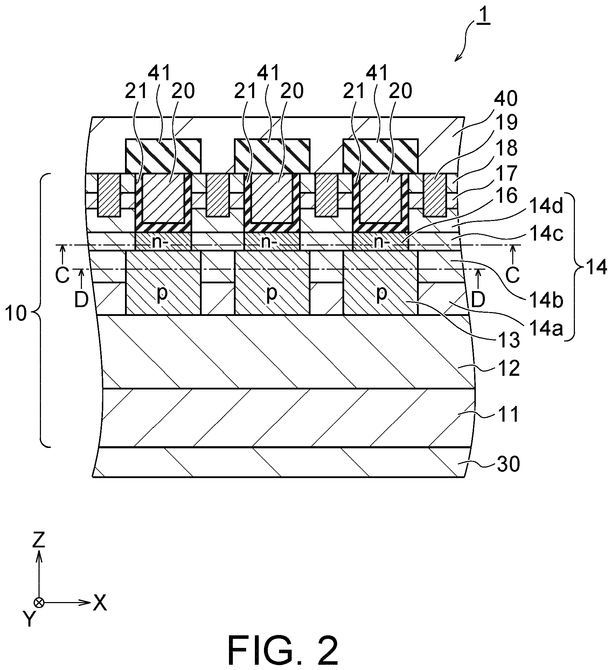

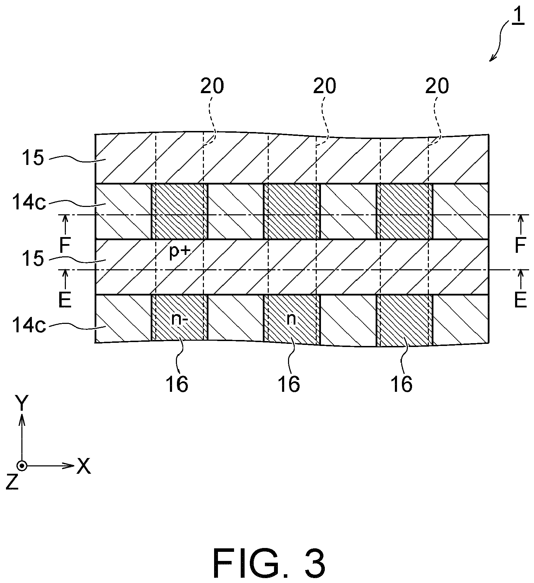

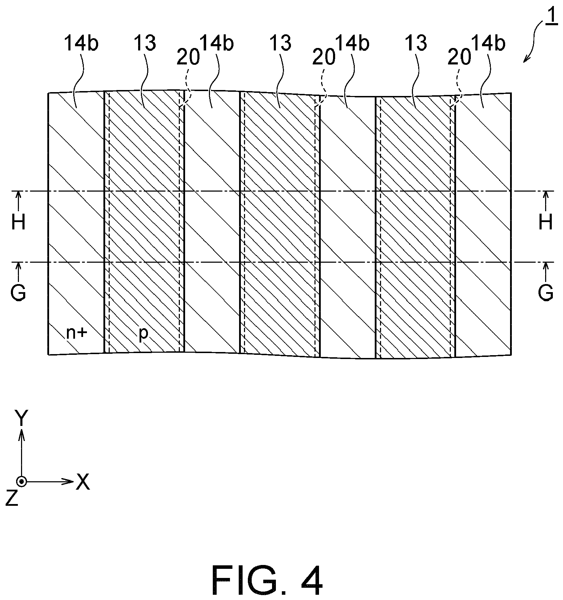

FIG. 1 is a cross sectional view of a semiconductor device according to a first embodiment that is cut in a perpendicular direction. FIG. 2 is a cross sectional view of the semiconductor device according to the first embodiment that is cut in the perpendicular direction at a portion different from that of FIG. 1. FIG. 3 is a cross sectional view taken along a cutting line A-A shown in FIG. 1 and a cutting line C-C shown in FIG. 2. FIG. 4 is a cross sectional view taken along a cutting line B-B shown in FIG. 1 and a cutting line D-D shown in FIG. 2. Note that FIG. 1 corresponds to a cross sectional view taken along a cutting line E-E shown in FIG. 3 and a cutting line G-G shown in FIG. 4. Further, FIG. 2 corresponds to a cross sectional view taken along a cutting line F-F shown in FIG. 3 and a cutting line H-H shown in FIG. 4.

A semiconductor device 1 according to the present embodiment is a MOSFET having a trench-gate structure. This semiconductor device 1 includes a semiconductor part 10, a gate electrode 20, a drain electrode 30, and a source electrode 40.

First, the semiconductor part 10 will be described. As shown in FIG. 1 to FIG. 4, the semiconductor part 10 includes a substrate 11, a drift region 12, a p-type semiconductor region 13, a current spreading region 14, a p⁺-type semiconductor region 15, an n⁻-type semiconductor region 16, a p-base region 17, an n⁺ source region 18, and a p⁺ contact region 19. The current spreading region 14 further includes a first current spreading region 14a, a second current spreading region 14b, a third current spreading region 14c, and a fourth current spreading region 14d.

In the present embodiment, the p⁺-type semiconductor region 15 corresponds to the first semiconductor region of the first conductivity type. Further, the p-type semiconductor region 13 corresponds to the second semiconductor region of the first conductivity type. Furthermore, the n⁻-type semiconductor region 16 corresponds to a third semiconductor region of a second conductivity type. In addition, the third current spreading region 14c corresponds to a fourth semiconductor region of the second conductivity type. Further, the first current spreading region 14a and the second current spreading region 14b correspond to a fifth semiconductor region of the second conductivity type. In addition, the drift region 12 corresponds to a sixth semiconductor region of the second conductivity type.

Further, in the following description, the arrangement and configuration of each portion of the semiconductor device are described using an X-axis, a Y-axis, and a Z-axis shown in each drawing in some instances. The X-axis, the Y-axis, and the Z-axis are orthogonal to one another, each representing an X-direction (second direction), a Y-direction (first direction), and a Z-direction (third direction). Further, some descriptions are made assuming that the Z-direction is directed upward and the opposite direction is directed downward. In the present embodiment, the X-direction and the Y-direction represent in-plane directions parallel to the substrate 11 and the Z-direction represents an out-of-plane direction orthogonal to the substrate 11.

Further, notations of n⁻, n, and n⁺ mean that an n-type impurity concentration becomes higher in this order. Further, the notations of p and p⁺ mean that a p-type impurity concentration becomes higher in this order.

In the semiconductor part 10, the substrate 11 is, for example, an n-type SiC substrate. On the substrate 11, the drift region 12 is provided.

The drift region 12 is an n⁻-type semiconductor region. The drift region 12 is depleted by a drain voltage applied between the drain electrode 30 and the source electrode 40 when the semiconductor device 1 is off. Therefore, the thickness of the drift region 12 is designed so as to satisfy a predetermined condition of a pressure resistance. On the drift region 12, a plurality of p-type semiconductor regions 13 is provided.

The plurality of p-type semiconductor regions 13 each extend in the Y-direction along the gate electrode 20 as shown in FIG. 4. Between the plurality of p-type semiconductor regions 13, the first current spreading regions 14a and the second current spreading regions 14b are provided as shown in FIGS. 1 and 2. That is, between the p-type semiconductor regions 13 that are adjacent to each other in the Y-direction, the first current spreading region 14a and the second current spreading region 14b are provided.

The first current spreading region 14a and the second current spreading region 14b are both an n-type semiconductor region. The first current spreading region 14a is provided on the drift region 12. The second current spreading region 14b is provided on the first current spreading region 14a.

The n-type impurity concentration of the second current spreading region 14b is equal to or higher than the n-type impurity concentration of the first current spreading region 14a. However, when the n-type impurity concentration of the first current spreading region 14a is high, decline in the pressure resistance of the semiconductor device 1 is concerned. Further, the second current spreading region 14b is provided in a site sandwiched between the p-type semiconductor regions 13, and thus, preferably has a resistance as low as possible. Therefore, the n-type impurity concentration of the second current spreading region 14b is preferably higher than the n-type impurity concentration of the first current spreading region 14a.

On the p-type semiconductor region 13 and the second current spreading region 14b, the p⁺-type semiconductor region 15 is provided as shown in FIG. 1. A part of the p⁺-type semiconductor region 15 projects in the Z-direction so as to contact a side surface of a gate insulation film 21. By means of this projecting portion, the p⁺-type semiconductor region 15 is electrically connected to the source electrode 40. Further, the p⁺-type semiconductor region 15 extends in the X-direction as shown in FIG. 3.

Further, as shown in FIG. 2, on the p-type semiconductor region 13 (between the p-type semiconductor region 13 and the gate insulation film 21 in the Z-direction), the n⁻-type semiconductor region 16 is also provided. The n⁻-type semiconductor region 16 is provided alternately with the p⁺-type semiconductor region 15 in the Y-direction as shown in FIG. 3. The n-type impurity concentration of the n⁻-type semiconductor region 16 is substantially the same as the n-type impurity concentration of the drift region 12.

Further, as shown in FIG. 3, between the plurality of n⁻-type semiconductor regions 16 in the X-direction, the third current spreading regions 14c are provided. The third current spreading region 14c is an n-type semiconductor region, as with the first current spreading region 14a and the second current spreading region 14b described above. The n-type impurity concentration of the third current spreading region 14c is equal to or higher than the n-type impurity concentration of the first current spreading region 14a and is equal to or lower than the n-type impurity concentration of the second current spreading region 14b.

However, the third current spreading region 14c is a current path when the semiconductor device 1 is on, and thus, preferably has a low resistance. On the other hand, since the third current spreading region 14c is disposed near a bottom portion of a trench, if the n-type impurity concentration is excessively high, the electric field of the gate insulation film 21 becomes high. Therefore, it is preferable that the n-type impurity concentration of the third current spreading region 14c be higher than the n-type impurity concentration of the first current spreading region 14a and be equal to or lower than that of the second current spreading region 14b.

As shown in FIG. 1 and FIG. 2, on the p⁺-type semiconductor region 15 and the n⁻-type semiconductor region 16, the gate insulation film 21 and the fourth current spreading region 14d are provided. More specifically, a plurality of gate insulation films 21 is provided in the X-direction, the gate insulation films 21 each extending in the Y-direction. Further, the fourth current spreading region 14d is provided between the gate insulation films 21 that are adjacent to each other in the X-direction. The gate insulation film 21 is, for example, a silicon oxide film (SiO₂).

The fourth current spreading region 14d is an n-type semiconductor region, as with the first current spreading region 14a to the third current spreading region 14c described above. The n-type impurity concentration of the fourth current spreading region 14d is equal to or higher than the n-type impurity concentration of the first current spreading region 14a and is equal to or lower than the n-type impurity concentration of the third current spreading region 14c.

However, on the fourth current spreading region 14d, the p-base region 17 is joined. Therefore, if the n-type impurity concentration of the fourth current spreading region 14d is excessively high, the p-base region 17 is depleted. Thus, it is preferable that the n-type impurity concentration of the fourth current spreading region 14d be higher than the n-type impurity concentration of the first current spreading region 14a and be lower than the n-type impurity concentration of the third current spreading region 14c.

On the p-base region 17 provided on the fourth current spreading region 14d, the n⁺ source region 18 is provided. The n⁺ source region 18 contacts the source electrode 40, together with the p⁺ contact region 19.

Next, the gate electrode 20, the drain electrode 30, and the source electrode 40 will be described.

The gate electrode 20 is formed inside the gate insulation film 21. That is, the gate electrode 20 is covered by the gate insulation film 21 and extends in the Y-direction. The gate electrode 20 may be formed using, for example, a polysilicon. The drain electrode 30 is provided on a back surface facing, in the Z-direction, a front surface where the semiconductor part 10 is provided of the substrate 11. The source electrode 40 is disposed facing, in the Z-direction, the drain electrode 30 across the semiconductor part 10. The source electrode 40 is electrically insulated from the gate electrode 20 by an interlayer dielectric 41. The drain electrode 30 and the source electrode 40 may be formed using metal.

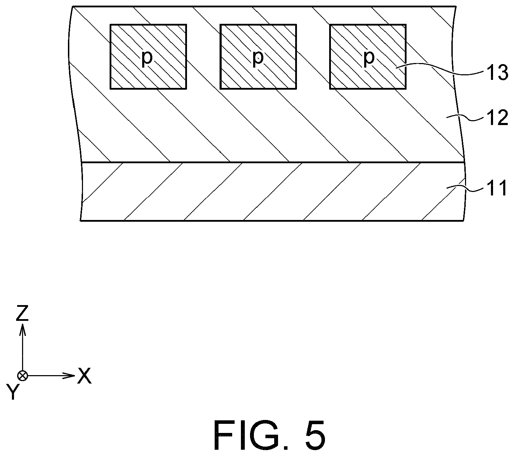

Next, with reference to FIG. 5 to FIG. 15, an example of a method for manufacturing the semiconductor device 1 configured as described above will be described.

First, as shown in FIG. 5, by ion implantation using a mask, the p-type semiconductor region 13 is formed inside the drift region 12 formed on the substrate 11. FIG. 5 is a cross sectional view of the same portion as that of FIG. 1. Note that at this time, the cross section shown in FIG. 2 is in the same structure as that shown in FIG. 5.

The material of the mask used in a step of forming the p-type semiconductor region 13 shown in FIG. 5 is, for example, an oxide film or a resist. Further, ions of aluminum (Al) or boron (B) are implanted as the p-type impurity. At this time, the ions are implanted at a tilt angle of 0° relative to the front surface of the substrate 11. Here, the tilt angle is an inclined angle relative to the Z-direction perpendicular to the front surface of the substrate 11. That is, when the tilt angle is 0°, the direction of implanting the ions is the Z-direction. Note that when the substrate 11 is a SiC substrate, the ions are implanted along the crystallographic of the SiC.

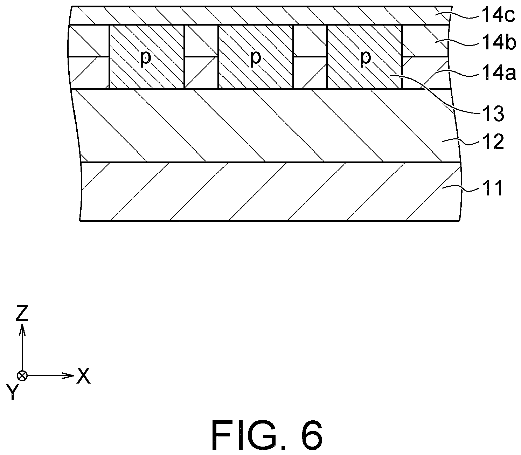

Next, as shown in FIG. 6, by ion implantation using a mask, the first current spreading region 14a, the second current spreading region 14b, and the third current spreading region 14c are sequentially formed inside the drift region 12. FIG. 6 is also a cross sectional view of the same portion as that of FIG. 1. Note that at this time, the cross section shown in FIG. 2 is also in the same structure as that shown in FIG. 6.

The mask used in a step of forming the first current spreading region 14a to the third current spreading region 14c is newly formed after removing the mask used in the step of forming the p-type semiconductor region 13. This mask protests a termination region (not shown) of the substrate 11 and opens in a cell region shown in FIG. 6. Therefore, since the ions implanted in this step are bounced back by the p-type semiconductor region 13, the positional deviation between each current spreading region and the p-type semiconductor region 13 can be avoided. Further, in this step, ions of nitrogen (N) or phosphorus (P) are implanted as the n-type impurity. At this time, the ions are implanted at a tilt angle of 0° relative to the front surface of the substrate 11. Note that when the substrate 11 is a SiC substrate, the ions are implanted along the crystallographic of the SiC. Further, the ion implantation amount and implantation time are adjusted so that the first current spreading region 14a to the third current spreading region 14c, which have different concentrations of the n-type impurity, may be formed.

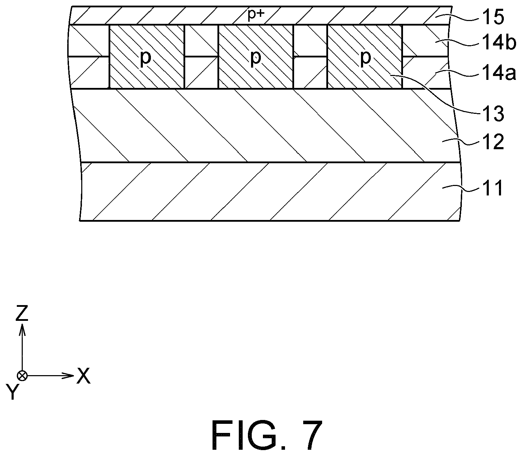

Next, as shown in FIG. 7, by ion implantation using a mask, the p⁺-type semiconductor region 15 is formed in a part of the third current spreading region 14c. FIG. 7 is a cross sectional view of the same portion as that of FIG. 1. In this step, ions of aluminum (Al) or boron (B) are implanted as the p-type impurity. At this time, the ion implantation amount and implantation time are adjusted so that the concentration of the p-type impurity of the p⁺-type semiconductor region 15 becomes higher than the concentration of the p-type impurity of the p-type semiconductor region 13.

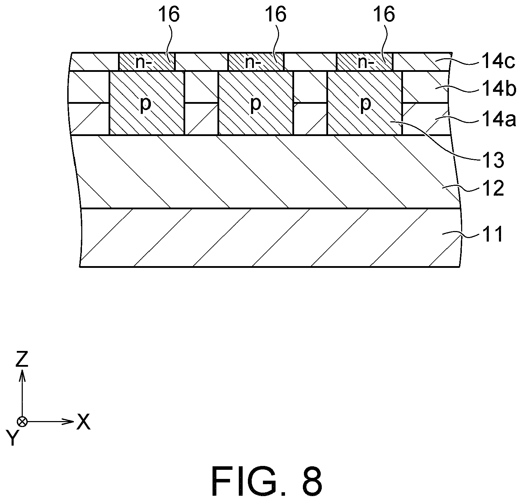

Next, as shown in FIG. 8, by ion implantation using a mask, the n⁻-type semiconductor region 16 is formed on the p-type semiconductor region 13 inside the third current spreading region 14c. FIG. 8 is a cross sectional view of the same portion as that of FIG. 2.

The mask used in a step of forming the n⁻-type semiconductor region 16 is newly formed after removing the mask used in the step of forming the p⁺-type semiconductor region 15. This mask opens in a region where the n⁻-type semiconductor region 16 is formed. As a result, as shown in FIG. 3, the p⁺-type semiconductor region 15 and the n⁻-type semiconductor region 16 form a lattice pattern.

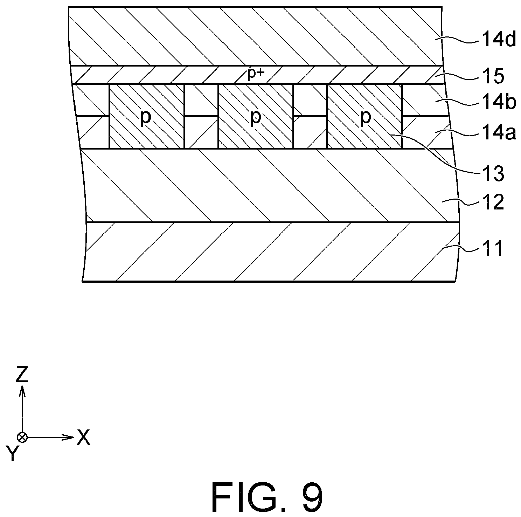

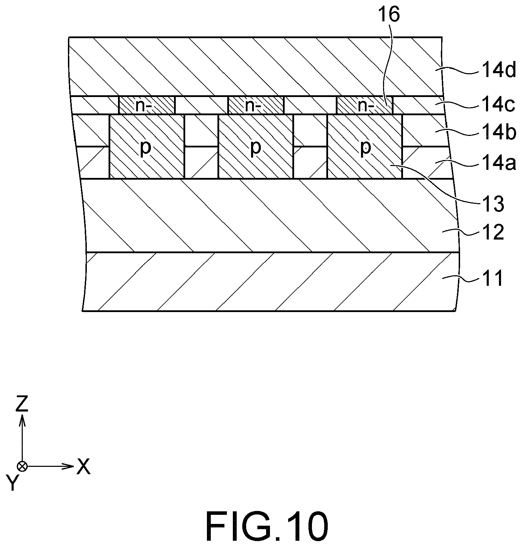

Next, as shown in FIG. 9 and FIG. 10, the fourth current spreading region 14d is formed on each of the p⁺-type semiconductor region 15, n⁻-type semiconductor region 16, and the third current spreading region 14c. FIG. 9 is a cross sectional view of the same portion as that of FIG. 1. Further, FIG. 10 is a cross sectional view of the same portion as that of FIG. 2. The fourth current spreading region 14d may be formed by, for example, epitaxial growth.

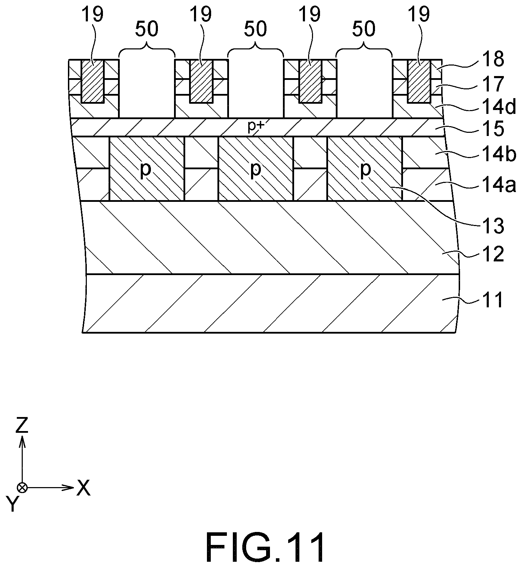

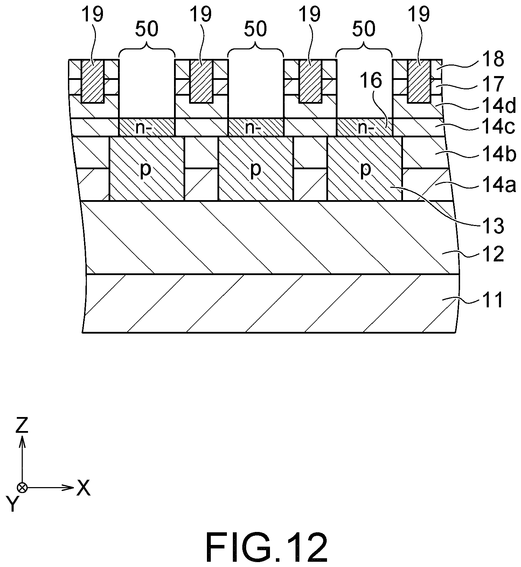

Next, as shown in FIG. 11 and FIG. 12, by ion implantation using a mask, the p-base region 17, the n⁺ source region 18, and the p⁺ contact region 19 are formed above the fourth current spreading region 14d. FIG. 11 is a cross sectional view of the same portion as that of FIG. 1. Further, FIG. 12 is a cross sectional view of the same portion as that of FIG. 2.

The p-base region 17 and the p⁺ contact region 19 may be formed by implantation of ions of aluminum or boron. On the other hand, the n⁺ source region 18 may be formed by implantation of ions of nitrogen or phosphorus.

Next, the trench 50 is formed by, for example, RIE (Reactive Ion Etching). The trench 50 extends through the p-base region 17, the n⁺ source region 18, and the fourth current spreading region 14d in the Z-direction and terminates in the p⁺-type semiconductor region 15 and the n⁻-type semiconductor region 16.

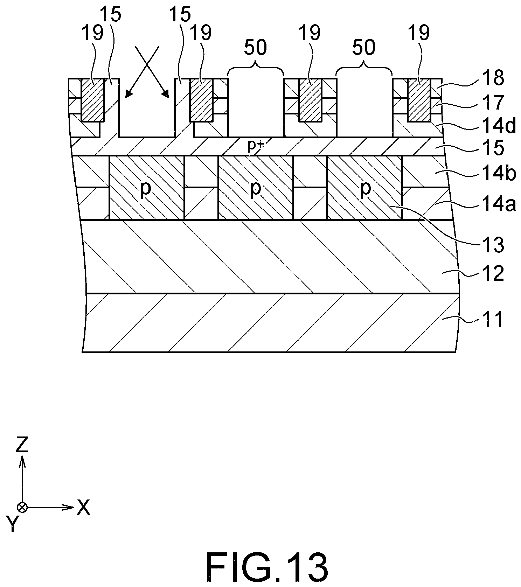

Next, as shown in FIG. 13, by ion implantation using a mask, the p⁺-type semiconductor region 15 is formed in a side wall portion of the trench 50. FIG. 13 is a cross sectional view of the same portion as that of FIG. 1.

The mask used in this step is patterned so as to partially expose the trench 50. Further, this p⁺-type semiconductor region 15 may be formed by implanting ions in a direction oblique to the Z-direction.

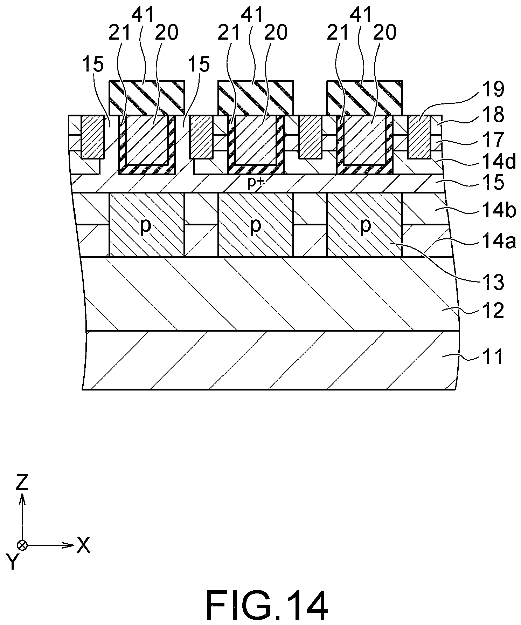

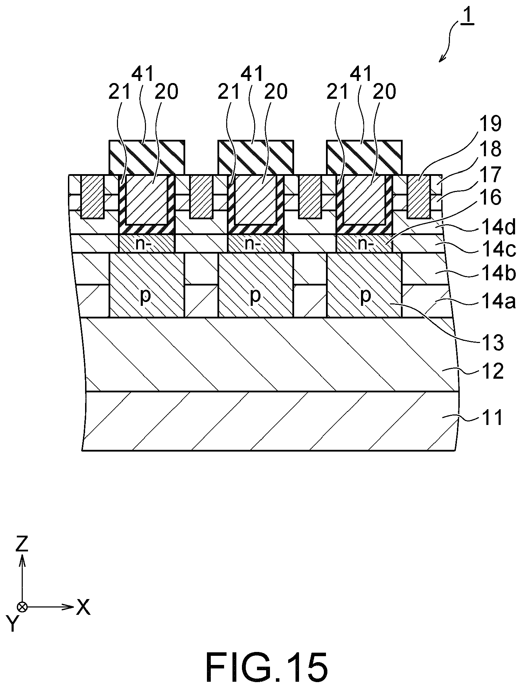

Next, as shown in FIG. 14 and FIG. 15, the gate insulation film 21 and the gate electrode 20 are sequentially formed inside the trench 50. Subsequently, the interlayer dielectric 41 is formed on the gate insulation film 21 and the gate electrode 20. FIG. 14 is a cross sectional view of the same portion as that of FIG. 1. Further, FIG. 15 is a cross sectional view of the same portion as that of FIG. 2.

Finally, as shown in FIG. 1 and FIG. 2, the source electrode 40 and the drain electrode 30 are formed so that the semiconductor device 1 according to the present embodiment is completed.

The aforementioned process of manufacturing is an example of the method for manufacturing the semiconductor device 1 according to the first embodiment and does not limit the method for manufacturing. For example, the p-type semiconductor region 13 may be formed such that a groove portion is formed and a p-type semiconductor is embedded in the groove portion, instead of implanting ions. Further, the p-type semiconductor region 13 may be formed by implanting ions from the trench 50.

According to the present embodiment described above, as shown in FIG. 1, the p-type semiconductor region 13 faces the gate insulation film 21 across the p⁺-type semiconductor region 15. The conductivity type of the p-type semiconductor region 13 is the same as the conductivity type of the p⁺-type semiconductor region 15. Further, the concentration of the p-type impurity of the p-type semiconductor region 13 is lower than the concentration of the p-type impurity of the p⁺-type semiconductor region 15. With the p-type semiconductor region 13 provided, the electric field exerted on the p⁺-type semiconductor region 15 can be suppressed, so that the p⁺-type semiconductor region 15 need not be thickened. In general, the resistance of the n-type semiconductor region surrounded by the p-type semiconductor region is low when the concentration of the impurity of the p-type semiconductor region is low. Therefore, in the present embodiment as well, the increase in the on resistance can be suppressed. Thus, it is possible to improve the reliability of the gate insulation film while suppressing the increase in the on resistance.

Further, in the present embodiment, as shown in FIG. 3, the p⁺-type semiconductor region 15 and the n⁻-type semiconductor region 16 are alternately disposed in the Y-direction. In this manner, as compared to a case in which the p⁺-type semiconductor region 15 is not present, an area of the third current spreading region 14c facing the gate insulation film 21 and the gate electrode 20 can be reduced. That is, since an area of the drain electrode 30 facing the gate electrode 20 is reduced, the reverse transfer capacitance of the semiconductor device 1 can be reduced.

Further, the n⁻-type semiconductor region 16 and the third current spreading region 14c are alternately disposed in the X-direction. The n-type impurity concentration of the n⁻-type semiconductor region 16 is low at around the same level as that of the n-type impurity concentration of the drift region 12, while the n-type impurity concentration of the third current spreading region 14c is higher than the n-type impurity concentration of the n⁻-type semiconductor region 16. As shown in FIG. 2, the n⁻-type semiconductor region 16 is provided below the gate insulation film 21, and the third current spreading region 14c is provided below the source electrode 40. In this manner, mitigation of the electric field of the gate insulation film 21 and reduction in the on resistance can both be achieved.

### (First modification)

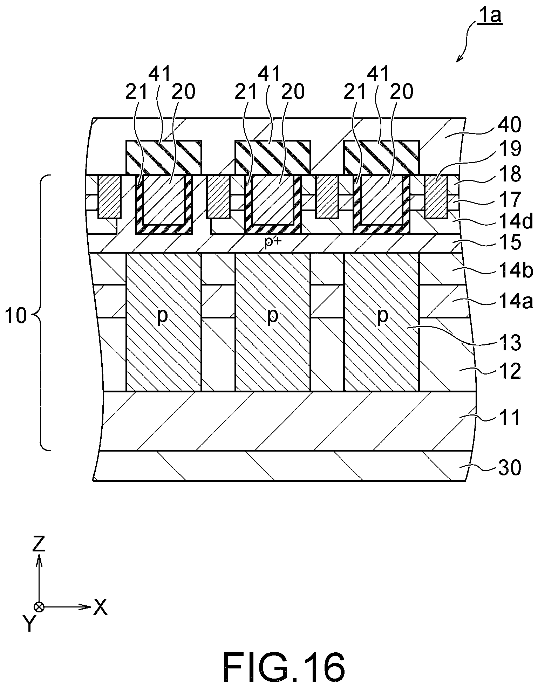

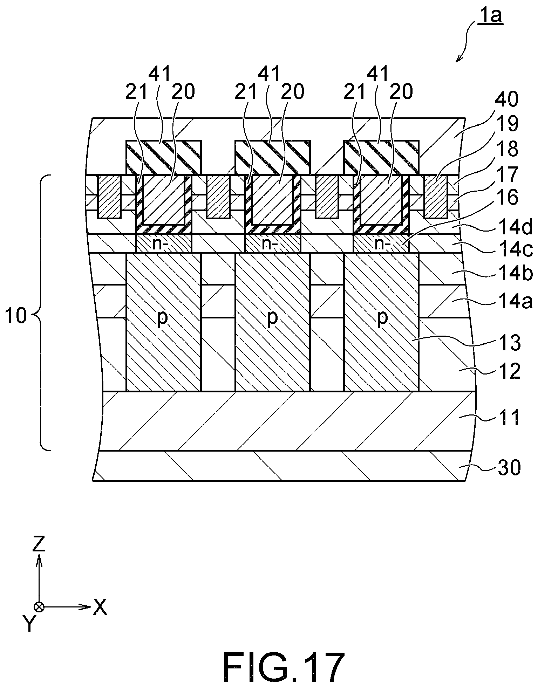

FIG. 16 is a cross sectional view of a semiconductor device according to a first modification that is cut in a perpendicular direction. FIG. 17 is a cross sectional view of the semiconductor device according to the first modification that is cut in the perpendicular direction at a portion different from that of FIG. 16. In FIG. 16 and FIG. 17, the same constituent elements as those of the semiconductor device 1 according to the first embodiment described above are assigned the same reference signs and the detailed descriptions are omitted. Note that the cross section shown in FIG. 16 corresponds to the cross section shown in FIG. 1. Further, the cross section shown in FIG. 17 corresponds to the cross section shown in FIG. 2.

In the semiconductor device 1 according to the first embodiment described above, as shown in FIG. 1 and FIG. 2, the p-type semiconductor region 13 terminates in the first current spreading region 14a. On the other hand, in a semiconductor device 1a according to the present modification, as shown in FIG. 16 and FIG. 17, the p-type semiconductor region 13 extends up to the drift region 12. That is, the semiconductor device 1a according to the present modification has a super junction (SJ) structure.

According to the present modification, a plurality of p-type semiconductor regions 13 is provided so as to be spaced apart from each other within the drift region 12 that is an n⁻-type semiconductor region. Therefore, within the drift region 12, the p-type semiconductor regions 13 and the n⁻-type semiconductor regions are alternately disposed in the X-direction. In this manner, when voltage is applied between the drain electrode 30 and the source electrode 40, the electric field intensity of the drift region 12 becomes uniform. Therefore, in the present modification, the resistance of the drift region 12 can be reduced as compared to the first embodiment. As a result, the on resistance can be reduced as compared to the first embodiment.

### (Second embodiment)

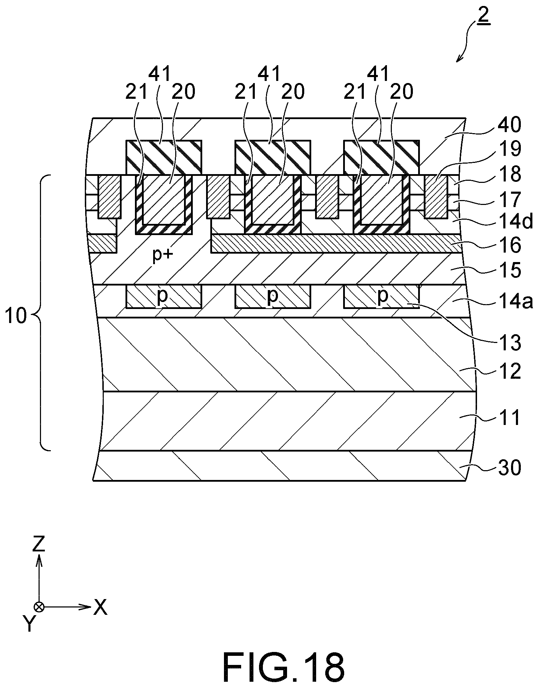

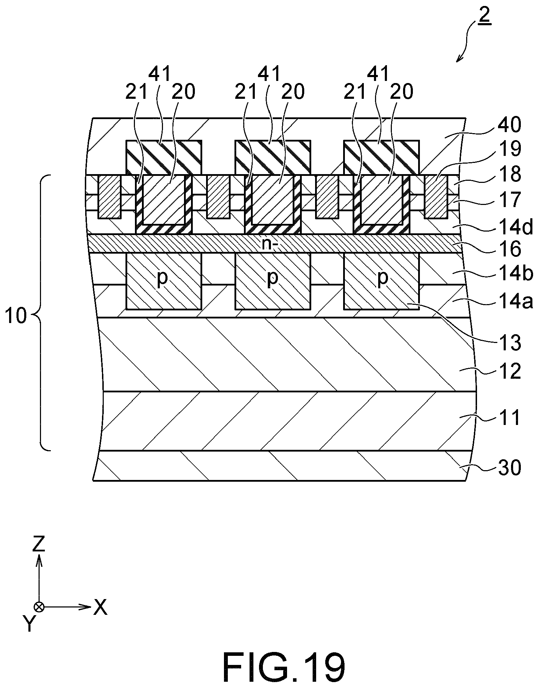

FIG. 18 is a cross sectional view of a semiconductor device according to a second embodiment that is cut in a perpendicular direction. FIG. 19 is a cross sectional view of the semiconductor device according to the second embodiment that is cut in the perpendicular direction at a portion different from that of FIG. 18. The cross section shown in FIG. 18 corresponds to the cross section shown in FIG. 1. Further, the cross section shown in FIG. 19 corresponds to the cross section shown in FIG. 2.

In FIG. 18 and FIG. 19, the same constituent elements as those of the semiconductor device 1 according to the first embodiment described above are assigned the same reference signs and the detailed descriptions are omitted. Further, a process of manufacturing a semiconductor device 2 according to the present embodiment is the same as that of the first embodiment. Therefore, the description of the method for manufacturing the semiconductor device 2 according to the present embodiment is also omitted.

As shown in FIG. 18, in the semiconductor device 2 according to the present embodiment as well, as in the first embodiment, the p-type semiconductor region 13 faces the gate insulation film 21 across the p⁺-type semiconductor region 15. On the other hand, as shown in FIG. 18 and FIG. 19, in the semiconductor device 2 according to the present embodiment, the semiconductor layer between the p⁺-type semiconductor region 15 and the gate insulation film 21 is the n⁻-type semiconductor region 16. Therefore, the present embodiment differs from the first embodiment in that the current spreading region 14 according to the present embodiment is not provided with the third current spreading region 14c.

Further, in the cross section shown in FIG. 19, the p-type semiconductor region 13 is provided on a lower layer of the n⁻-type semiconductor region 16. Therefore, this p-type semiconductor region 13 is thicker than the p-type semiconductor region 13 (see FIG. 18) provided on a lower layer of the p⁺-type semiconductor region 15. That is, the present embodiment differs from the first embodiment also in that two types of the p-type semiconductor regions 13 having different thicknesses are provided in the present embodiment. Note that as shown in FIG. 18, the bottom surface and the side surface of a part of the gate insulation film 21 are provided with the p⁺-type semiconductor region 15 for grounding the source electrode 40.

In the present embodiment, when the semiconductor device 2 is on, the n⁻-type semiconductor region 16 becomes a part of the current path from the drain electrode 30 leading to the source electrode 40. Further, when the semiconductor device 2 is off, the n⁻-type semiconductor region 16 is depleted to mitigate the electric field of the gate insulation film 21. In the present embodiment, the n-type impurity concentration of the n⁻-type semiconductor region 16 is preferably lower than the n-type impurity concentration of the drift region 12. Further, the thickness of the n⁻-type semiconductor region 16 is preferably thin as much as possible.

According to the present embodiment described above, as shown in FIG. 18, the p-type semiconductor region 13 faces the gate insulation film 21 across the p⁺-type semiconductor region 15. Therefore, as in the first embodiment, without thickening or thinning the p⁺-type semiconductor region 15 more than necessary, the increase in the on resistance can be suppressed. Thus, it is possible to improve the reliability of the gate insulation film while suppressing the increase in the on resistance.

Further, in the present embodiment, as shown in FIG. 18 and FIG. 19, the bottom surface of the gate insulation film 21 is provided with the n⁻-type semiconductor region 16 that is thinner than the p⁺-type semiconductor region 15. Furthermore, in the present embodiment as well, the p-type semiconductor region 13 extends in the Y-direction along the gate electrode 20. In addition, as shown in FIG. 18, the p⁺-type semiconductor region 15 orthogonal to the gate electrode 20 is connected to the source electrode 40. By having such a structure, the semiconductor device 2 according to the present embodiment can achieve both improvement in reliability of the gate insulation film 21 and reduction in the on resistance.

### (Second modification)

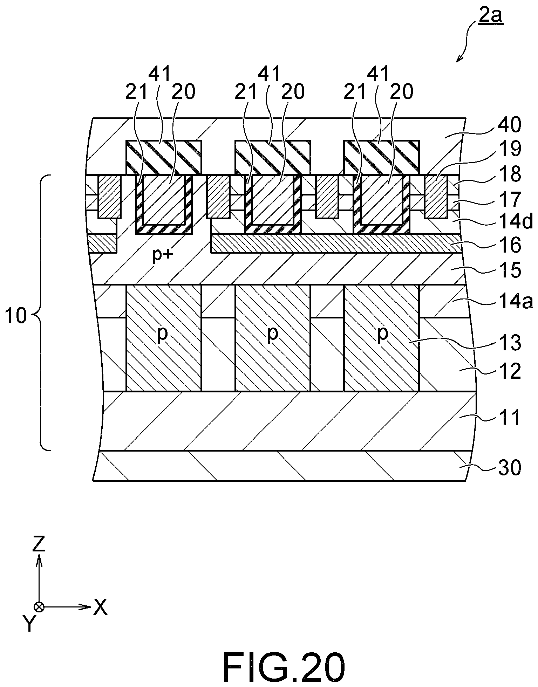

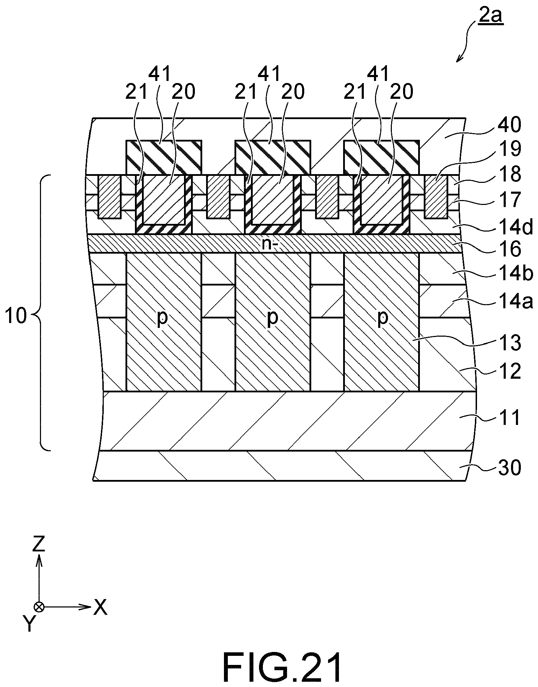

FIG. 20 is a cross sectional view of a semiconductor device according to a second modification that is cut in a perpendicular direction. FIG. 21 is a cross sectional view of the semiconductor device according to the second modification that is cut in the perpendicular direction at a portion different from that of FIG. 20. In FIG. 20 and FIG. 21, the same constituent elements as those of the semiconductor device 2 according to the second embodiment described above are assigned the same reference signs and the detailed descriptions are omitted. Note that the cross section shown in FIG. 20 corresponds to the cross section shown in FIG. 18. Further, the cross section shown in FIG. 21 corresponds to the cross section shown in FIG. 19.

In the semiconductor device 2 according to the second embodiment described above, as shown in FIG. 18 and FIG. 19, the p-type semiconductor region 13 terminates in the first current spreading region 14a. On the other hand, in a semiconductor device 2a according to the present modification, as shown in FIG. 20 and FIG. 21, the p-type semiconductor region 13 extends up to the drift region 12. That is, the semiconductor device 2a according to the present modification has the super junction (SJ) structure, as with the semiconductor device 1a according to the first modification described above.

Accordingly, in the present modification as well, when voltage is applied between the drain electrode 30 and the source electrode 40, the electric field intensity of the drift region 12 becomes uniform. Therefore, in the present modification, the resistance of the drift region 12 can be reduced as compared to the second embodiment. As a result, the on resistance can be reduced as compared to the second embodiment.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.
It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A semiconductor device comprising:
a gate electrode (20) extending in a first direction (Y);
a gate insulation film (21) that covers the gate electrode (20);
a first semiconductor region (15) of a first conductivity type extending in a second direction (X) orthogonal to the first direction (Y) below the gate insulation film (21); and
a second semiconductor region (13) of the first conductivity type that faces the gate insulation film across the first semiconductor region (15), wherein
an impurity concentration of the first conductivity type of the second semiconductor region (13) is lower than that of the first semiconductor region (15).

2. The semiconductor device according to claim 1, further comprising a third semiconductor region (16) of a second conductivity type that is alternately provided with the first semiconductor region (15) in the first direction (Y) below the gate insulation film (21).

3. The semiconductor device according to claim 2, further comprising
a fourth semiconductor region (14c) of the second conductivity type that is alternately provided with the third semiconductor region (16) in the second direction (X), wherein
an impurity concentration of the second conductivity type of the fourth semiconductor region (14c) is higher than that of the third semiconductor region (16).

4. The semiconductor device according to claim 2 or 3, wherein the second semiconductor region (13) is also provided below the third semiconductor region (16).

5. The semiconductor device according to any one of claims 2 to 4, further comprising a fifth semiconductor region (14a, 14b) of the second conductivity type that is provided below the first semiconductor region (15) and the third semiconductor region (16), wherein
the second semiconductor region (13) is provided inside the fifth semiconductor region (14a, 14b).

6. The semiconductor device according to any one of claims 2 to 4, further comprising:
a fifth semiconductor region (14a, 14b) of the second conductivity type that is provided below the first semiconductor region (15) and the third semiconductor region (16); and
a sixth semiconductor region (12) of the second conductivity type that is provided below the fifth semiconductor region (14a, 14b), wherein the second semiconductor region (13) extends from the fifth semiconductor region up to the sixth semiconductor region (12).

7. The semiconductor device according to any one of claims 2 to 6, wherein the first conductivity type is a p-type and the second conductivity type is an n-type.

8. The semiconductor device according to claim 1, further comprising a third semiconductor region (16) of a second conductivity type that is provided between the gate insulation film (21) and the first semiconductor region (15).

9. The semiconductor device according to claim 8, wherein a thickness of the second semiconductor region (13) provided below the third semiconductor region (16) is greater than that of the second semiconductor region (13) provided below the first semiconductor region (15).

10. The semiconductor device according to any one of claims 3, 8 or 9, further comprising:
a fifth semiconductor region (14a, 14b) of the second conductivity type that is provided below the first semiconductor region (15) and the third semiconductor region (16);
a sixth semiconductor region (12) of the second conductivity type that is provided below the fifth semiconductor region (14a, 14b);
a SiC substrate (11) provided below the sixth semiconductor region (12);
a drain electrode (30) provided on a back surface of the SiC substrate (11); and
a source electrode (40) that faces the drain electrode in a third direction (Z) orthogonal to the first direction and the second direction, the source electrode being electrically insulated from the gate electrode (20) by an interlayer dielectric (41).

11. The semiconductor device according to any one of claim 5, further comprising:
a sixth semiconductor region (12) of the second conductivity type that is provided below the fifth semiconductor region (14a, 14b).

12. The semiconductor device according to claim 6 or 11, further comprising:
a SiC substrate (11) provided below the sixth semiconductor region (12);
a drain electrode (30) provided on a back surface of the SiC substrate (11); and
a source electrode (40) that faces the drain electrode in a third direction (Z) orthogonal to the first direction and the second direction, the source electrode being electrically insulated from the gate electrode (20) by an interlayer dielectric (41).

13. The semiconductor device according to any one of claims 8 to 12, wherein the first conductivity type is a p-type and the second conductivity type is an n-type.

14. The semiconductor device according to any one of claims 1 to 13, wherein the second semiconductor region (13) extends in the first direction (Y) along the gate electrode (20).
